# EUROPEAN PATENT SPECIFICATION

(11) **EP 0 504 758 B1**
(45) Date of publication and mention of the grant of the patent: **18.06.1997**
(21) Application number: 92104397.2
(22) Date of filing: 13.03.1992
(51) Int. Cl.: H01L 21/3213, H01L 21/306, H01L 21/311

(54) **Plasma etching method for silicon containing layer**
Plasma-Ätzverfahren einer Silizium enthaltenden Schicht
Méthode de gravure par plasma d'une couche comprenant du silicium

(30) Priority: 19.03.1991 JP 78317/91
(43) Date of publication of application: 23.09.1992
(73) Proprietor: TOKYO ELECTRON LIMITED, Minato-ku, Tokyo 107 (JP)
(72) Inventor: Higuchi, Fumihiko, c/o OPERATIONAL HEAD OFFICE, 2-30-7 Sumiyoshi-cho, Fuchu Tokyo 183 (JP); Fukasawa, Yoshio, c/o OPERATIONAL HEAD OFFICE, 2-30-7 Sumiyoshi-cho, Fuchu Tokyo 183 (JP)
(74) Representative: Hansen, Bernd, Dr. Dipl.-Chem.

(56) References cited:
- EP-A- 0 256 311
- EP-A- 0 272 143
- EP-A- 0 328 350
- EP-A- 0 350 997
- EP-A- 0 474 244
- US-A- 4 431 477
- US-A- 4 502 915
- DATABASE WPI Week 8039, Derwent Publications Ltd., London, GB; AN 80-68463C

## Description

The present invention relates to an etching method for a silicon containing layer of an object having a SiO₂ film and a silicon containing layer adjacent thereto. This invention is applied, for example, to a case when a polysilicon layer, which is adjacent to the SiO₂ film in a semiconductor wafer, is etched.

US-4502915 describes a two-step plasma process for selective and isotropic etching of polycrystalline silicon. In the described process, the silicon is initially etched with a non-selective plasma etching gas in the first step until the first layer, which may contain contaminants is removed, and is then further etched in the second step, wherein selective plasma etching is performed by using hydrogen chloride and hydrogen bromide diluted with helium as the etching gas.

EP 474 244 (prior art under Art 54(3) EPC) discloses a plasma processing method, wherein the plasma generation gas consists of hydrogen bromide or a gas mixture comprising hydrogen bromide, and may further contain hydrogen chloride, oxygen, chlorine and/or sulfur hexafluoride. The hydrogen bromide or the hydrogen bromide gas mixture can be diluted with helium or similar gases. The method described in EP 474 244 is said to be applicable to numerous silicon-containing films formed on a silicon oxide or nitride film, provided on a semiconductive substrate with high selectivity.

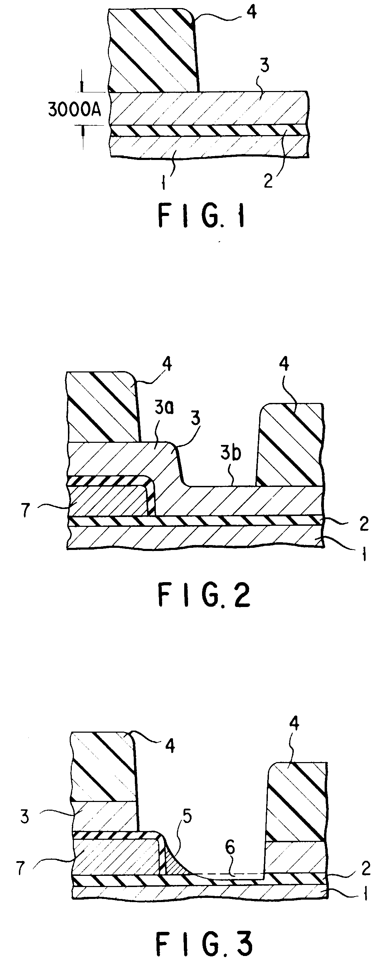

A dry etching of polysilicon has been used in for example a MOS transistor. As shown in Fig. 1, a MOS semiconductor wafer is formed of a silicon substrate 1, a SiO₂ gate insulating film 2 having a thickness of 10,0 to 30,0 nm formed on the silicon substrate 1, a polysilicon layer 3 having a thickness of about 300 nm (3000 Å) formed on the gate insulating film 2, and a resist film 4 formed on the polysilicon layer 3. In etching the polysilicon layer 3 in such a semiconductor wafer, a mixture of HBr gas and Cℓ₂ gas or HCℓ gas is used.

However, as shown in Fig. 2, in a portion where the polysilicon layer 3 is step-like formed, a portion 3a whose thickness is larger than the other portions is provided since a wire layer is further formed on a wire layer 7. As a result, in a case where the portion 3a and a portion 3b having a normal thickness are etched to be removed, the portion 3b is first removed by etching. As a result, as shown in Fig. 3, a residual portion 5 is generated at a portion corresponding to the portion 3a. Then, if the residual portion 5 is completely removed, the gate insulating film 2 is etched and a removal portion 6 shown in Fig. 3 may be formed. In other words, the part of the gate insulating film 2 is undesirably removed.

Since it is necessary to suppress damage of the Si substrate in etching polysilicon in the MOS semiconductor wafer, it is unfavorable that the above removed portion is formed. Therefore, it is required that the polysilicon layer be etched so as to have a high selection ratio to the SiO₂ gate insulating film, that is, (etching speed of polysilicon)/(etching speed of SiO₂). If the selection ratio is sufficiently high, the removal portion 6 can be considerably made small, and etching can be performed with a high accuracy of size.

However, in the conventional polysilicon etching, the selection ratio is about 30 and this is insufficient for the accuracy of size.

The present invention has been made in consideration of the above-mentioned problem, and an object of the invention is to provide a method for etching a silicon containing layer wherein the silicon containing layer can be etched at a high selection ratio to the SiO₂ layer in an object to be processed in which the silicon containing layer such as a polysilicon layer is formed on the SiO₂ layer.

According to the present invention there is provided a method for etching a silicon containing layer in an object to be processed having a SiO₂ film and a silicon containing layer which is adjacent to the SiO₂ film and which is formed of silicon-containing material other than SiO₂, comprising the steps of generating a plasma of a processing gas containing HBr and HCℓ gases, and selectively exposing a predetermined portion of the silicon containing layer in the plasma, thereby etching the portion, wherein the processing gas also includes at least one gas containing oxygen or nitrogen, with the proviso that the method does not comprise a step of irradiating the gas in the plasma generation area with light of a wavelength of not more than 436 nm, prior to the plasma generation.

This invention can be more fully understood from the following detailed description when taken in conjunction with the accompanying drawings, in which:
Fig. 1 is a cross sectional view showing a portion where a polysilicon layer in a semiconductor wafer is to be etched;
Fig. 2 is a cross sectional view showing the portion where the polysilicon layer in the semiconductor wafer is to be etched and the polysilicon layer is step-like formed;
Fig. 3 is a cross sectional view showing a state that the polysilicon layer of Fig. 2 is etched;
Fig. 4 is a cross sectional view showing one example of the apparatuses executing the present invention;
Fig. 5 is a schematic view showing a state that load lock chambers for carrying in and out are provided in the apparatus of Fig. 4;
Fig. 6 is a graph showing an etching rate of each of the polysilicon layer, SiO₂ layer, and a resist layer, in a case where HCℓ and HBr gas are used as gas containing halogen element and HBr gas flow is changed;
Fig. 7 is a graph showing a selection ratio of the polysilicon layer to the SiO₂ layer, a selection ratio of the polysilicon layer to the resist layer, and a uniformity of the polysilicon layer, in a case where HCℓ and HBr gas are used as gas containing halogen element and HBr gas flow is changed;

The inventors of the present invention studied variously in view of a processing gas in connection with a method for etching a silicon containing layer at a high selection ratio to a SiO₂ layer. As a result, the inventors found out that the selection ratio was able to be considerably increased by adding a gas containing oxygen or nitrogen in processing gas. More particulary, in a case where SiO₂ is dissociated by ion impact due to plasma, oxygen in a processing gas is recombined with dissociated Si. On the other hand, a thin SiN film is formed on the surface of the SiO₂ layer by existence of nitrogen in a processing gas, thereby protecting the SiO₂ layer. Therefore, etching of the SiO₂ layer can be suppressed, and the silicon containing layer can be etched at a high selection ratio to the SiO₂ layer by adding gas containing oxygen or nitrogen to a processing gas. The present invention has been made based on the above-mentioned findings of the inventors of the present invention.

The present invention will be explained in detail.

The present invention is applied to an object to be processed having a SiO₂ film and a silicon containing layer which is adjacent to the SiO₂ film and which is formed of silicon-containing material other than SiO₂. As such an object to be processed, a semiconductor wafer in which a polysilicon film is formed on the SiO₂ film serving as an insulating film can be used. As a silicon containing layer, silicide such as WSi and silicon nitride can be used other than polysilicon.

In plasma-etching the silicon containing layer of such an object to be processed, there is used at least one of a gas containing oxygen or nitrogen together with HCℓ and HBr gases as processing gas. The etching is performed by following procedures. The object to be processed is provided in a processing chamber. The inside of the treating chamber is depressurized. A treating gas is supplied therein. Plasma of processing gas is formed in the chamber. A predetermined portion of the silicon containing layer of the object is selectively exposed in plasma.

The mixed gas of HCℓ and HBr is favorable and the flow rate thereof is 10 : 1 to 2 : 1 is preferable.

A gas containing oxygen or nitrogen is not limited as long as oxygen or nitrogen is contained. However, O₂, N₂O, CO₂, CO, N₂, and NO₂ is preferable.

the ratio of the flow rate of a gas containing oxygen or nitrogen to that of the processing gas is preferably 10% or less. If this type of gas is slightly contained, the above-mentioned effect can be expected. However, if the flow rate ratio exceeds 10%, the etching speed decreases. The favorable flow rate ratio ranges from 1 to 4.5%.

The pressure in the processing chamber while etching process is preferably 133.3 Pa (1 Torr) or less.

In a case where the plasma-etching is performed as mentioned above, gas containing oxygen or nitrogen may be added in the treated gas from the beginning. However, during predetermined time in which there is not possibility of removal of SiO₂ layer, only HCℓ and HBr gases are supplied and etching is performed. Oxygen or nitrogen is added to the processing gas after etching advances close to the SiO₂ layer.

The following explains an apparatus for executing the above-mentioned method.

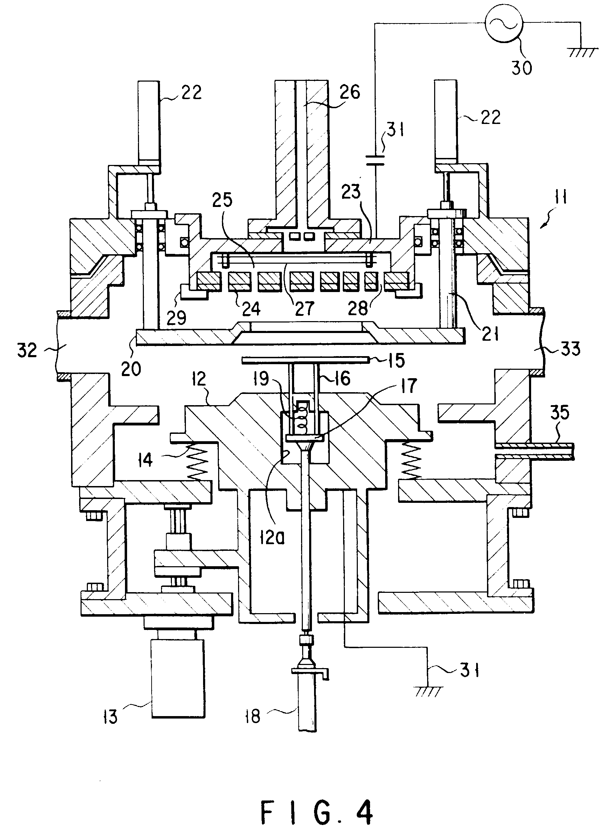

Fig. 4 is a view showing one example of a plasma etching apparatus to which the present invention is applied. This apparatus comprises a processing chamber 11 whose inside is maintained to be substantially air-tight. The processing chamber 11 is formed of, for example aluminum the surface of which is anodized.

In the lower portion of the processing chamber 11, a lower electrode 12 is provided. The lower electrode 12 is formed of, for example, aluminum the surface of which is anodized.

In the lower electrode 12, there is formed a mounting section having a trapezoidal cross section in its central portion, and an object 15 to be processed, for example, a semiconductor wafer is mounted thereon. A surface portion of the electrode 12 except for the portion where the object is mounted is preferably coated with an insulating material, such as Teflon (trade name). Due to the coating, there can be improved a focus effect in which discharging concentrates on the object 15.

The lower electrode 12 can be lifted by a lifter 13 with a maximum stroke of, for example, 30 mm. The airtight in the chamber 11 during lifting the lower electrode 12 is ensured by a bellows 14 made of, for example, stainless steel.

In the lower electrode 12, a space 12a is formed in its central portion. A plurality of through holes (for example, four) which are through upward from the space 12a, and a lifter pin 16 made of, for example, stainless steel is inserted into each through hole. The lifter pin 16 is connected to a lift mechanism 18 via a plate 17. The lifter pin 16 is lifted by the drive of a lift mechanism 18. The lifter pin 16 moves up, so that the object 15 is separated from the lower electrode 12 to be in a transferable state. The lifter pin 16 moves down, so that the object 15 is mounted on the lower electrode 12. In order to buffer the movement of the lifter pin 16, the lower electrode 12 and the plate 17 are connected to each other by a coil spring 19.

A clamp ring 20 is provided above the lower electrode 12. The clamp ring 20 is used for uniformly pressing the object 15 to the surface of the lower electrode 12, and fixing the object 15 thereto. The central portion of the clamp ring 20 is shaped to correspond to the mounting portion of the lower electrode 12. The clamp ring 20 is formed of material having no influence on plasma, for example aluminum, the surface of which is anodized, quartz, and ceramic material such as alumina. The clamp ring 20 is held by a plurality of shafts 21 (for example four) which are airtightly through the upper portion of the chamber 11. Each shaft is connected to an independent driving mechanism such as an air cylinder 22, and each shaft moves up and down by the corresponding driving mechanism. The lower electrode 12 is moved up in a state that the object 15 is mounted on the lower electrode 12. Due to this, the object 15 is brought into contact with the clamp ring 20. Moreover, the lower electrode 12 is moved up, so that the clamp ring 20 clamps the object 15 by pressing force of the air cylinder 22. While necessary pressing force is maintained the clamp ring 20 can be further moved up to a predetermined height, for example, by 5 mm by adjusting the drive of the air cylinder 22.

A conductive material 23 is provided at the top portion of the chamber 11. The conductive material 23 is formed of, for example aluminum, the surface of which is anodized. An upper electrode 24, which is electrically connected to the conductive material 23, is provided away from the conductive material 23 with a narrow space 25. The upper electrode 24 is formed of, for example, amorphous carbon, aluminum, or aluminum the surface of which is anodized.

A gas supply pipe 26 communicates with a space 25. The gas supply pipe 26 introduces processing gas from a gas supply source (not shown), which is arranged in the outside of the chamber 11, together with carrier gas. As processing gas, at least one of a gas containing oxygen or nitrogen is added to the HBr and HCl gases. Moreover, oxygen or nitrogen may be added to the HBr and HCl gases after etching advances up to the portion near the SiO₂ layer.

In the space 25, there are formed a plurality of baffles 27 having a plurality of openings in order to uniformly diffuse gas. A plurality of holes 28 is formed in the upper electrode 24 in order to supply gas diffused by baffles 27 into the chamber 11.

Note that, a shield ring 29, which is formed of insulating material such as Teflon, is provided in the peripheral portion of the upper electrode 24, and plasma can be generated to have the same diameter as the object 15.

A high frequency power supply 30 is connected to the upper electrode 24 via a capacitor 31 and the conductive material 23, and the lower electrode 12 is earthed. High frequency power is supplied to these electrodes from the power supply 30, so that plasma of processing gas generates between the electrodes. In this case, a plasma mode is a mode in which a radical etching is performed.

The high voltage electrode is used as the lower electrode 12 and the upper electrode 24 is earthed, so that the mode can be in a reactant ion etching (RIE) mode. Moreover, RF electric power whose phase differs at 180 degrees can be supplied between the upper electrode 24 and the lower electrode 12. Furthermore, there may be used a magnetron etching type in which magnet is provided above or around the chamber 11, a crossed electromagnetic field is formed between the electrodes, and etching is performed. By use of magnet, etching treatment can be performed under a low pressure condition with high efficiency.

A gas exhaust port 35 is formed in the lower side portion of the chamber 11, and the chamber 11 is exhausted from the gas exhaust port 35 by a vacuum pump (not shown).

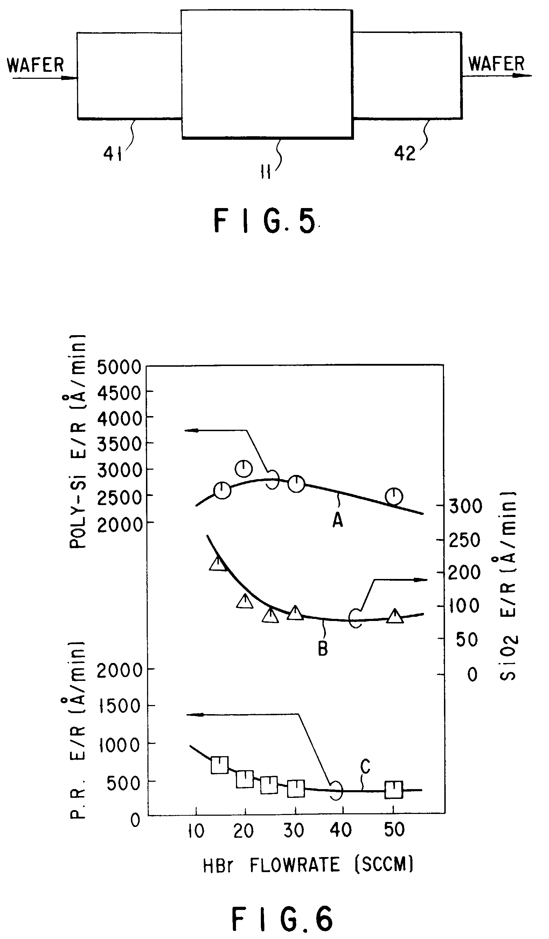

In the two side surfaces of the chamber 11 opposing to each other, an inlet 32 for carrying in the object to be processed and an outlet 33 for carrying out the object are provided. Moreover, as schematically shown in Fig. 5, load lock chambers 41 and 42 for carrying in and out are formed to be continuous to the inlet 32 and the outlet 33. These load lock chambers 41 and 42 have inlet and outlet side gates, respectively, and are able to be exhausted. By the provision of these load lock chambers 41 and 42, the object 15 (for example a semiconductor wafer) can be carried in and out without having the inside of the chamber 11 come in contact with air.

In performing plasma etching by use of the above-mentioned apparatus, first of all, one object to be processed is taken up by a sender (not shown) and inserted into the load lock chamber 41 for carrying in. The inlet side gate of the load lock chamber 41 is closed, and the inside thereof is exhausted. Thereafter, the outlet side gate is opened, and the object 15 is carried in the portion above the lower electrode 12 by a carrying-in mechanism (not shown). The lifter pin 16 is moved up and the object 15 is received at the top end of the lifter pin 16, and the carrying-in mechanism is retracted. Thereafter, the inside of the chamber 11 is made airtight. The lifter pin 16 is moved down, so that the object 15 is mounted on the lower electrode 12. Then, the lower electrode 12 is moved up, and the surroundings of the object 15 is brought into contact with the clamp ring 20, and the object 15 is fixed to the clamp ring 20.

The inside of the chamber 11 is exhausted, processing gas is introduced therein via the gas supply pipe 26 from the gas supply source, and the inside of the chamber is made to have a predetermined pressure, for example, 133.3 Pa (1 Torr) or less.

Thereafter, RF electric power is supplied between the upper electrode 24 and the lower electrode 12, and plasma of processing gas is generated therebetween. By means of the plasma, the silicon containing layer of the object 15 is etched.

After etching, as the inside of the chamber 11 is exhausted, the lower electrode 12 is moved down and the lifter pin 16 is moved up, and the object 15 is mounted thereon. Then, the object 15 is carried out via the load lock chamber 42 for carrying out by an carrying-out mechanism (not shown).

An Example of the present invention will be explained as follows.

### Example 1

Example 1 explains the case in which a semiconductor wafer is used as a object to be processed, and a polysilicon layer thereof is etched.

In this Example, the above-mentioned etching apparatus was used, and HCℓ of 200 SCCM and HBr of 30 SCCM, both serving as processing gas, were introduced to the chamber. The pressure of the inside of the chamber was set to be 6.66 Pa (50m Torr), and high frequency electric power of 225W was supplied between the electrodes from high frequency power supply of 13. 56 MHz, and a polysilicon layer (having a thickness of 300 nm (3000 Å)) of the semiconductor wafer was etched. The distance between the electrodes was set to be 0.6 cm.

The etching treatment was made during the time in which the polysilicon layer was all etched in view of the calculation. Thereafter, oxygen or nitrogen containing gas such as O₂, CO₂, N₂O were added to a processing gas at the various flow rates, respectively. An over-etching was performed for 60 min. under the same condition, and a residual portion of the polysilicon layer was removed. For comparison, there was an experiment in which oxygen or nitrogen containing gas is not added in over-etching, and the experimental result was shown in Table 1. The flow rate of oxygen or nitrogen containing gas was set to be 1, 3, 5, 10, and 15 SCCM.

**Table 1**

| Gas Flow Rate | O₂ | CO₂ | N₂O |
|---|---|---|---|
| 0 SCCM | 12,0 nm/min | 12,0 nm/min | 12,0 nm/min |
| 1 SCCM | 8,0 nm/min | 7,7 nm/min | 5,4 nm/min |
| 3 SCCM | 0,8 nm/min | - | - |
| 5 SCCM | 0 nm/min | 2,7 nm/min | 0 nm/min |
| 10 SCCM | 0 nm/min | 0 nm/min | 0 nm/min |
| 15 SCCM | 0 nm/min | 0 nm/min | 0 nm/min |

As shown in Table 1, the etching rate of the base SiO₂ layer was 12,0 nm/min in the case in which O₂, CO₂, and N₂O gases were not added. In contrast, in the case in which O₂, CO₂, and N₂O gases were added, the etching rate of the SiO₂ layer was reduced to 8,0 to 5,4 nm/min even if the flow rate was 1 SCCM. Particularly, the etching rate of the SiO₂ layer was considerably reduced when these rates were 3 SCCM or more, and the etching rate of the SiO₂ layer was 0 when the rate was 5 SCCM in the case of O₂, N₂O. When these flow rates were 10 SCCM or more in the case of all gases, the etching rate of the SiO₂ layer was 0.

In this case, the etching rate of the polysilicon layer was about 250 nm/min.

As a result, the following fact was confirmed.

The selection ratio of silicon to the base SiO₂ layer increased by these additive gases. Particularly, by adding gases at the rate of 3 SCCM or more, the selection rate of about 50 was increased to 100 to infinity.

Moreover, there was a tendency that the etching shape was slightly deteriorated when the additive gas was 15 SCCM. In view of this point, it was confirmed that the flow rate of additive gas was favorably 3 to 10 SCCM. The flow rate corresponds to the flow rate ratio of 1.3 to 4.2% to the flow rate of the processing gas.

The above result shows the case in which O₂, CO₂, N₂O were individually added. In the case in which these gases were mixed and the total amount was set as Table 1, substantially the same result as Table 1 was obtained.

Next, an experiment on influence of the flow rate ratio on the etching was conducted in the case in which HCℓ and HBr gases both serving as halogen element containing gases were used.

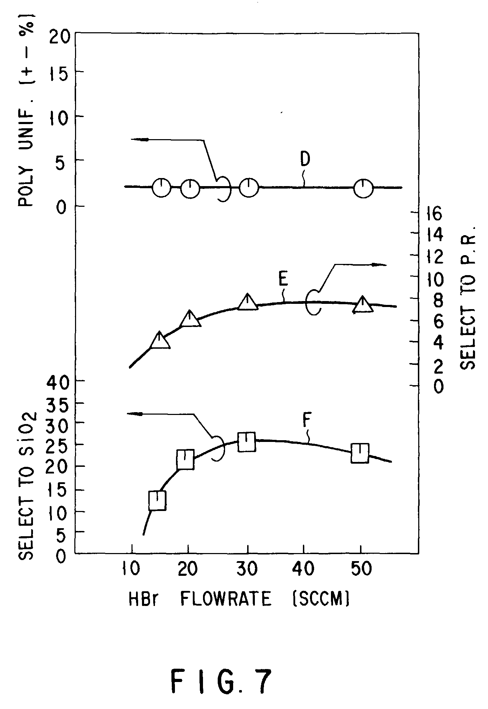

In this case, the flow rate of HCℓ gas was set to 200 SCCM, and the flow rate of HBr gas was changed in the rate of 15 to 50 SCCM. Then, the etching was performed in a state that the pressure of the inside of the chamber was set to 80 Pa (600m Torr), high frequency electric power was 250 W, and the temperature was 20°C. The result was shown in Figs. 6 and 7. In Fig. 6, a curve A is a resist etching rate, a curve B is an etching rate of the SiO₂ layer, and a curve C is an etching rate of the polysilicon layer. In Fig. 7, a curve D is a selection ratio of the polysilicon layer to the SiO₂ layer, a curve E is a selection ratio of the polysilicon to the resist layer, and a curve F is uniformity of the polysilicon layer.

As shown in these figures, it was confirmed that HCℓ gas of 200 SCCM and HBr gas of 20 to 40 SCCM were favorably added in order to obtain a favorable etching having a high etching rate of polysilicon and a high selection ratio of the polysilicon layer to SiO₂.

The present invention relates to the etching method of the silicon containing layer, and the etching method is not limited to the plasma etching using the opposing electrodes. It is needless to say that the other method in which, for example, an ECR is used, may be employed.

## Claims

1. A method for etching a silicon containing layer in an object to be processed having a SiO₂ film and a silicon containing layer which is adjacent to the SiO₂ film and which is formed of silicon-containing material other than SiO₂, comprising the steps of:
generating a plasma of a processing gas containing HBr gas, HCl gas and at least one oxygen-containing gas or nitrogen-containing gas; and
selectively exposing a predetermined portion of the silicon containing layer in the plasma, thereby etching said portion, with the proviso that the method does not comprise a step of irradiating the gas in the plasma generation area with light of a wavelength of not more than 436 nm, prior to the plasma generation.

2. The method according to claim 1, characterized in that said gas containing oxygen or nitrogen is at least one selected from a group consisting of O₂ gas, N₂O gas, CO₂ gas, CO gas, N₂ gas, and NO₂ gas.

3. The method according to claim 1, characterized in that a flow rate ratio of HCl gas and HBr gas is 10:1 to 2:1.

4. The method according to claim 1, characterized in that a ratio of a flow rate of said gas containing oxygen or nitrogen to that of said processing gas is 10% or less.

5. The method according to claim 4, characterized in that the ratio of the flow rate of said gas containing oxygen or nitrogen to that of said processing gas is 1 to 4.5%.

6. The method according to claim 1, characterized in that the plasma of said processing gas is generated by supplying said processing gas to a chamber where said object to be processed is inserted, and by supplying high frequency electric power between a pair of electrodes opposing to each other.

7. The method according to claim 6 characterized in that the pressure in the chamber is set to 133.3 Pa (1 Torr) or less when the plasma is generated.

8. The method according to claim 1, characterized in that said silicon containing layer is a polysilicon layer.

9. A method for etching a silicon containing layer in an object to be processed having a SiO₂ film and a silicon containing layer which is adjacent to the SiO₂ film and which is formed of silicon-containing material other than SiO₂, comprising the steps of:
generating a plasma of a processing gas containing HBr gas and HCl gas;
selectively exposing a predetermined portion of the silicon containing layer in the plasma thereby etching said portion;
adding at least one gas containing oxygen or nitrogen to the processing gas at the time when said silicon containing layer is etched to a predetermined thickness by plasma; and
etching a residual portion of said silicon containing layer by plasma of the processing gas in which said gas containing oxygen or nitrogen is added.

10. The method according to claim 9, characterized in that said gas containing oxygen or nitrogen is at least one selected from a group consisting of O₂ gas, N₂O gas, CO₂ gas, CO gas, N₂ gas, and NO₂ gas.

11. The method according to claim 9, characterized in that a flow rate ratio of HCl gas and HBr gas is 10:1 to 2:1.

12. The method according to claim 9, characterized in that a ratio of a flow rate of said gas containing oxygen or nitrogen to that of said processing gas is 10% or less.

13. The method according to claim 12, characterized in that the ratio of the flow rate of said gas containing oxygen or nitrogen to that of said processing gas is 1 to 4.5%.

14. The method according to claim 9, characterized in that the plasma of said processing gas is generated by supplying said processing gas to a chamber where the said object to be processed is inserted, and by supplying high frequency electric power between a pair of electrodes opposing to each other.

15. The method according to claim 14, characterized in that the pressure in the chamber is set to 133 Pa (1 Torr) or less when the plasma is generated.

16. The method according to claim 9, characterized in that said silicon containing layer is a polysilicon layer.

## Patentansprüche

1. Verfahren zum Ätzen einer Silicium enthaltenden Schicht in einem zu bearbeitenden Gegenstand, der einen SiO₂-Film und eine Silicium enthaltende Schicht, welche dem SiO₂-Film benachbart ist und welche aus einem anderen Silicium enthaltenden Material als SiO₂ gebildet ist, aufweist, das die folgenden Schritte umfaßt:
- Erzeugen eines Plasmas aus einem Bearbeitungsgas, das HBr-Gas, HCl-Gas und mindestens einem Gas, das Sauerstoff oder Stickstoff enthält, umfaßt; und
- Belichten eines vorher bestimmten Teils der Silicium enthaltenden Schicht in dem Plasma und dadurch Ätzen dieses Teils in selektiver Weise unter der Voraussetzung, daß das Verfahren vor der Plasmaerzeugung keinen Schritt einer Bestrahlung des Gases in dem Plasmaerzeugungsbereich mit Licht einer Wellenlänge von nicht mehr als 436 nm umfaßt.

2. Verfahren nach Anspruch 1,
dadurch **gekennzeichnet**,
daß das Gas, das Sauerstoff oder Stickstoff enthält, mindestens eines ist, das aus der aus O₂-Gas, N₂O-Gas, CO₂-Gas, N₂-Gas und NO₂-Gas bestehenden Gruppe ausgewählt wird.

3. Verfahren nach Anspruch 1,
dadurch **gekennzeichnet**,
daß das Verhältnis der Strömungsgeschwindigkeiten von HCl-Gas und HBr-Gas 10:1 bis 2:1 ist.

4. Verfahren nach Anspruch 1,
dadurch **gekennzeichnet**,
daß das Verhältnis der Strömungsgeschwindigkeit des Gases, das Sauerstoff oder Stickstoff enthält, zu der des Bearbeitungsgases 10 % oder weniger ist.

5. Verfahren nach Anspruch 4,
dadurch **gekennzeichnet**,
daß das Verhältnis der Strömungsgeschwindigkeit des Gases, das Sauerstoff oder Stickstoff enthält, zu der des Bearbeitungsgases 1 bis 4,5 % ist.

6. Verfahren nach Anspruch 1,
dadurch **gekennzeichnet**,
daß das Plasma aus dem Bearbeitungsgas erzeugt wird, indem das Bearbeitungsgas in eine Kammer geleitet wird, in die der zu bearbeitende Gegenstand eingesetzt wurde, und zwischen ein Paar Elektroden, die einander gegenüber angeordnet sind, elektrische Hochfrequenz-Leistung geführt wird.

7. Verfahren nach Anspruch 6,
dadurch **gekennzeichnet**,
daß der Druck in der Kammer auf 133,3 Pa (1 Torr) oder weniger eingestellt ist, wenn das Plasma erzeugt wird.

8. Verfahren nach Anspruch 1,
dadurch **gekennzeichnet**,
daß die Silicium enthaltende Schicht eine Polysiliciumschicht ist.

9. Verfahren zum Ätzen einer Silicium enthaltenden Schicht in einem zu bearbeitenden Gegenstand, der einen SiO₂-Film und eine Silicium enthaltende Schicht, welche dem SiO₂-Film benachbart ist und welche aus einem anderen Silicium enthaltenden Material als SiO₂ gebildet ist, aufweist, das die folgenden Schritte umfaßt:
- Erzeugen eines Plasmas aus einem Bearbeitungsgas, das HBr-Gas und HCl-Gas enthält;
- Belichten eines vorher bestimmten Teils der Silicium enthaltenden Schicht in dem Plasma und dadurch Ätzen dieses Teils in selektiver Weise;
- Zusetzen mindestens eines Gases, das Sauerstoff oder Stickstoff enthält, zu dem Bearbeitungsgas zu dem Zeitpunkt, in dem die Silicium enthaltende Schicht bis zu einer vorher festgelegten Dicke durch das Plasma geätzt ist; und
- Ätzen eines Restteils der Silicium enthaltenden Schicht durch das Plasma des Bearbeitungsgases, dem das Gas, das Sauerstoff oder Stickstoff enthält, zugesetzt ist.

10. Verfahren nach Anspruch 9,
dadurch **gekennzeichnet**,
daß das Gas, das Sauerstoff oder Stickstoff enthält, mindestens eines ist, das aus der aus O₂-Gas, N₂O-Gas, CO₂-Gas, CO-Gas, N₂-Gas und NO₂-Gas bestehenden Gruppe ausgewählt wird.

11. Verfahren nach Anspruch 9,
dadurch **gekennzeichnet**,
daß das Verhältnis der Strömungsgeschwindigkeiten von HCl-Gas und HBr-Gas 10:1 bis 2:1 ist.

12. Verfahren nach Anspruch 9,
dadurch **gekennzeichnet**,
daß das Verhältnis der Strömungsgeschwindigkeit des Gases, das Sauerstoff oder Stickstoff enthält, zu der des Bearbeitungsgases 10 % oder weniger ist.

13. Verfahren nach Anspruch 12,
dadurch **gekennzeichnet**,
daß das Verhältnis der Strömungsgeschwindigkeit des Gases, das Sauerstoff oder Stickstoff enthält, zu der des Bearbeitungsgases 1 bis 4,5 % ist.

14. Verfahren nach Anspruch 9,
dadurch **gekennzeichnet**,
daß das Plasma aus dem Bearbeitungsgas erzeugt wird, indem das Bearbeitungsgas in eine Kammer geleitet wird, in die der zu bearbeitende Gegenstand eingesetzt wurde, und zwischen ein Paar Elektroden, die einander gegenüber angeordnet sind, elektrische Hochfrequenz-Leistung geführt wird.

15. Verfahren nach Anspruch 14,
dadurch **gekennzeichnet**,
daß der Druck in der Kammer auf 133 Pa (1 Torr) oder weniger eingestellt ist, wenn das Plasma erzeugt wird.

16. Verfahren nach Anspruch 9,
dadurch **gekennzeichnet**,
daß die Silicium enthaltenden Schicht eine Polysiliciumschicht ist.

## Revendications

1. Procédé de gravure d'une couche contenant du silicium dans un objet à traiter, présentant un film de SiO₂ et une couche contenant du silicium qui est adjacente au film de SiO₂ et qui est formée d'un matériau contenant du silicium autre que SiO₂, comprenant les étapes consistant à:
produire un plasma d'un gaz de traitement contenant du HBr gazeux, du HCl gazeux et au moins un gaz contenant de l'oxygène ou un gaz contenant de l'azote; et
exposer sélectivement une partie prédéterminée de la couche contenant du silicium dans le plasma, pour ainsi graver ladite partie, avec la condition que le procédé ne comprenne pas une étape d'irradiation du gaz dans la région de production du plasma, par une lumière d'une longueur d'onde non supérieure à 436 nm, avant la production du plasma.

2. Procédé selon la revendication 1, caractérisé en ce que ledit gaz contenant de l'oxygène ou de l'azote est au moins un gaz choisi dans un groupe constitué de O₂ gazeux, N₂O gazeux, CO₂ gazeux, CO gazeux, N₂ gazeux et NO₂ gazeux.

3. Procédé selon la revendication 1, caractérisé en ce qu'un rapport entre les débits du HCl gazeux et du HBr gazeux est de 10:1 à 2:1.

4. Procédé selon la revendication 1, caractérisé en ce qu'un rapport entre le débit dudit gaz contenant de l'oxygène ou de l'azote et celui dudit gaz de traitement est de 10% ou moins.

5. Procédé selon la revendication 4, caractérisé en ce que le rapport entre le débit dudit gaz contenant de l'oxygène ou de l'azote, et celui dudit gaz de traitement, est de 1 à 4,5%.

6. Procédé selon la revendication 1, caractérisé en ce que le plasma dudit gaz de traitement est produit en amenant ledit gaz de traitement dans une chambre dans laquelle ledit objet à traiter est inséré, et en fournissant une énergie électrique à haute fréquence entre une paire d'électrodes opposées l'une à l'autre.

7. Procédé selon la revendication 6, caractérisé en ce que la pression dans la chambre est fixée à 133,3 Pa (1 Torr) ou moins lorsque le plasma est produit.

8. Procédé selon la revendication 1, caractérisé en ce que ladite couche contenant du silicium est une couche de polysilicium.

9. Procédé de gravure d'une couche contenant du silicium dans un objet à traiter, présentant un film de SiO₂ et une couche contenant du silicium qui est adjacente au film de SiO₂ et qui est formée d'un matériau contenant du silicium autre que SiO₂, comprenant les étapes consistant à:
produire un plasma d'un gaz de traitement contenant du HBr gazeux et du HCl gazeux;
exposer de manière sélective une partie prédéterminée de la couche contenant du silicium dans le plasma, pour ainsi graver ladite partie;
ajouter au moins un gaz contenant de l'oxygène ou de l'azote au gaz de traitement, au moment où ladite couche contenant du silicium est gravée sur une épaisseur prédéterminée par le plasma; et
graver une partie résiduelle de ladite couche contenant du silicium par un plasma du gaz de traitement auquel est ajouté le gaz contenant de l'oxygène ou de l'azote.

10. Procédé selon la revendication 9, caractérisé en ce que ledit gaz contenant de l'oxygène ou de l'azote est au moins un gaz choisi dans un groupe constitué de O₂ gazeux, N₂O gazeux, CO₂ gazeux, CO gazeux, N₂ gazeux et NO₂ gazeux.

11. Procédé selon la revendication 9, caractérisé en ce qu'un rapport entre les débits du HCl gazeux et du HBr gazeux est de 10:1 à 2:1.

12. Procédé selon la revendication 9, caractérisé en ce qu'un rapport entre le débit dudit gaz contenant de l'oxygène ou de l'azote et celui dudit gaz de traitement est de 10% ou moins.

13. Procédé selon la revendication 12, caractérisé en ce que le rapport entre le débit dudit gaz contenant de l'oxygène ou de l'azote et celui dudit gaz de traitement est de 1 à 4,5%.

14. Procédé selon la revendication 9, caractérisé en ce que le plasma dudit gaz de traitement est produit en amenant ledit gaz de traitement dans une chambre dans laquelle ledit objet à traiter est inséré, et en fournissant une énergie électrique à haute fréquence entre une paire d'électrodes opposées l'une à l'autre.

15. Procédé selon la revendication 14, caractérisé en ce que la pression dans la chambre est fixée à 133 Pa (1 Torr) ou moins lorsque le plasma est produit.

16. Procédé selon la revendication 9, caractérisé en ce que ladite couche contenant du silicium est une couche de polysilicium.
